Europäisches Patentamt

European Patent Office

Office européen des brevets

(19)

(11) EP 0 876 677 B1

(12) **EUROPÄISCHE PATENTSCHRIFT**

(45) Veröffentlichungstag und Bekanntmachung des Hinweises auf die Patenterteilung:
21.07.1999 Patentblatt 1999/29

(21) Anmeldenummer: 97902212.6

(22) Anmeldetag: 23.01.1997

(51) Int Cl.$^6$: **H01J 37/317**

(86) Internationale Anmeldenummer:
PCT/EP97/00319

(87) Internationale Veröffentlichungsnummer:
WO 97/27613 (31.07.1997 Gazette 1997/33)

(54) **IONENQUELLE FÜR EINE IONENSTRAHLANLAGE**

ION SOURCE FOR AN ION BEAM ARRANGEMENT

SOURCE IONIQUE POUR SYSTEME A FAISCEAU IONIQUE

(84) Benannte Vertragsstaaten:
CH DE FR GB LI NL

(30) Priorität: 23.01.1996 DE 19602283
09.05.1996 DE 19618733
09.05.1996 DE 19618734
13.01.1997 DE 19700856

(43) Veröffentlichungstag der Anmeldung:
11.11.1998 Patentblatt 1998/46

(73) Patentinhaber: FRAUNHOFER-GESELLSCHAFT ZUR FÖRDERUNG DER ANGEWANDTEN FORSCHUNG E.V.
80636 München (DE)

(72) Erfinder:
• SCHORK, Rainer
D-91330 Bammersdorf (DE)

• RYSSEL, Heiner
D-91080 Spardorf (DE)

(74) Vertreter: Schoppe, Fritz, Dipl.-Ing.
Schoppe & Zimmermann
Patentanwälte
Postfach 71 08 67
81458 München (DE)

(56) Entgegenhaltungen:
EP-A- 0 405 855 DE-A- 3 708 716
US-A- 5 396 076

• PATENT ABSTRACTS OF JAPAN vol. 096, no. 008, 30. August 1996 & JP 08 096742 A (NISSIN ELECTRIC CO LTD), 12. April 1996

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die vorliegende Erfindung bezieht sich auf eine Vorrichtung zur großflächigen Implantation von Ionen für eine Ionenstrahlanlage gemäß dem Oberbegriff des Patentanspruchs 1.

Ionenquellen finden ihre technische Anwendung in Bereichen, in denen ein großflächiger homogener Ionenstrahl erforderlich ist. Dies ist beispielsweise bei der Grßflächenionenimplantation zur Dotierung von Halbleitern, bei der Tribologie zur Oberflächenhärtung und bei der ionenstrahlunterstützten Beschichtung der Fall. Eine gattungsgemäße Vorrichtung ist aus der JP-A-2-20018 bekannt.

Der Trend in der Ionenimplantation für die hochintegrierte Mikroelektronik geht zu geringeren Ionenenergien bei größeren Implantationsflächen. Die Höchstintegration mit mehr als $10^7$ Bauelementen pro Schaltung verlangt eine Reduzierung der pn-Übergangstiefe. Zum Beispiel sind in der CMOS-Technologie für die Drain und die Source ultrafache pn-Übergänge mit einer Tiefe von weniger als 100 nm erforderlich. Die Herstellung von immer flacheren pn-Übergängen bereitet vor allem bei der Implantation von Bor für $p^+$-Gebiete große technologische Schwierigkeiten. Die hierfür erforderlichen Anforderungen an die Ionenimplantation, wie z.B. eine geringe Ionenenergie deutlich unterhalb von 30 keV, hoher Ionenstrom bzw. hoher Durchsatz, paralleler Strahl bei großen Implantationsflächen und hohe Homogenität werden von derzeit erhältlichen kommerziellen Anlagen nicht erfüllt.

Ein weiteres Leistungsmerkmal für zukünftige Halbleiterfertigungsgeräte ist die Integrierbarkeit in sogenannten Mehrkammerprozeßanlagen, die auch als Cluster-Systeme bezeichnet werden. Dies erfordert die Entwicklung kleiner Prozeßmodule, die von einem zentralen Roboter mit Prozeßscheiben bedient werden können. Solche System haben den Vorteil, daß mehrere Prozeßschritte in einer Anlage ausgeführt werden können. Durch die steigende Anzahl an Prozeßschritten bei der Halbleiterfertigung und höhere Anforderungen an die Flexibilität des Fertigungsprozesses gewinnen solche Anlagen immer mehr an Bedeutung. Herkömmliche Implantationsanlagen eignen sich nicht für eine Integration in eine Mehrkammerprozeßanlage, da sie in ihren Abmessungen zu groß sind. Die immer komplexer und teuerer werdenden kommerziellen Anlagen erfordern weiterhin einen hohen Wartungsaufwand und eine große Reinraumfläche, was wiederum zu hohen Betriebskosten führt.

Um den genannten Anforderungen Rechnung tragen zu können, ist eine neue Ionenstrahltechnologie nötig. Eine Möglichkeit bietet die sogenannte "Plasma Immersion Ion Implantation", kurz PIII. In solchen Anlagen wird mittels hochfrequenter elektromagnetischer Anregungen ein Plasma in der Implantationskammer ausgebildet. Die Ionendichte in diesem Bereich beträgt in der Regel $10^{10}$ bis $10^{11}$ cm$^{-3}$. Durch Anlegen einer negativen Spannung, die bis zu einigen Kilovolt betragen kann, werden die positiven Ionen aus dem Plasma in Richtung einer Probe, die zu bearbeiten ist, beschleunigt. Eine PIII-Anlage hat eine Reihe von Vorteilen, wie z.B. hoher Ionenstrom, niedrige Prozeßkosten und ist ein kompaktes, wartungsarmes System, welches sich sehr gut für Mehrkammerprozeßanlagen eignet.

Obwohl das PIII-Verfahren schon lange bekannt ist, konnte es sich bisher nicht bei der Implantation bei der Halbleitertechnologie durchsetzen. Die Gründe hierfür sind die unscharfe Energieverteilung (Energiekontamination), die inhomogene Dosisverteilung und die Kontamination der Proben mit Schwermetallen oder unerwünschten Ionenarten.

Bekannte Ionenquellen für die Erzeugung grogßflächiger Ionenstrahlen sind die Hochfrequenz- und die Elektron-Zyklotron-Resonanz-Ionenquelle.

Bei Hochfrequenz-Ionenquellen (HF-Ionenquelle) liegt der Arbeitsdruck bei etwa $10^{-3}$ bis $10^{-2}$ mbar. Bei diesen Ionenquellen ist die einfache Bauart und der geringe Leistungsbedarf von Vorteil. Die Hochfrequenz wird kapazitiv bzw. induktiv eingekoppelt. Ist ein sehr sauberes Plasma erforderlich, besteht der Plasmareaktor aus einem Quarzdom. Durch die Verwendung eines Quarzdoms wird die Hochfrequenzeinkopplung und ein gleichmäßig verteilter Gaseinlaß in den Plasmaraum erschwert. Um diese Nachteile, die zu inhomogenen Ionenverteilungen und höheren Arbeitsdrücken führen, zu vermeiden, werden bei vielen Herstellern Metallteile im Plasmaraum eingesetzt. Dies wiederum führt zu einer Metallkontamination auf den Prozeßscheiben und schließt eine Verwendung dieser Ionenquellenart für die großflächige Ionenimplantation aus. Die herkömmlichen großflächigen HF-Ionenquellen sind deshalb nur für Ionenätzen geeignet. Da beim Ätzen sich die Kontaminationen an der Oberfläche befinden und nicht in den Halbleiter implantiert werden, können diese wieder entfernt werden.

Elektron-Zyklotron-Resonanz-Ionenquellen (ECR-Ionenquellen) zeichnen sich aufgrund der Elektron-Zyklotron-Resonanz durch eine höhere Plasmadichte ($10^{12}$ bis $10^{13}$ cm$^{-3}$) als Hochfrequenzplasmen ($10^{10}$ bis $10^{11}$ cm$^{-3}$) aus. Daher arbeiten diese Quellen bei einem geringeren Prozeßdruck im Bereich von $10^{-5}$ bis $10^{-2}$ mbar. Ein Nachteil der ECR-Ionenquellen ist die durch das Magnetfeld entstehende Divergenz des Ionenstrahls. Ebenso wie im Falle der HF-Quellen ist für Anwendungen im Halbleiterbereich zur Reduzierung der Kontaminationn ein Quarzdom erforderlich. Dies erschwert auch hier den gleichmäßig verteilten Gaseinlaß und die Mikrowelleneinkopplung. Es werden daher bei manchen Herstellern Metallteile im Plasmaraum verwendet. Die ECR-Quellen werden für die herkömmliche Ionenimplantation (mit Massenseparation) und für Ätzanwendungen verwendet. Für die großflächige Ionenimplantation sind sie aus den bisher ungelösten Kontaminationsproblemen und aufgrund der hohen magnetischen Felder nicht einsetzbar. Weiterhin nimmt mit zunehmender Größe die Homogenität des Plasmas ab, da die ECR-Bedingung meist nur am Rand des Plasmas erfüllt wird. Eine solche ECR-Ionenquelle ist beispielsweise aus der DE 3708716 A1 bekannt.

Eine weitere bekannte Ionenquelle ist die sogenannte Kaufmannionenquelle, die jedoch für viele Anwendungen aus Kontaminationsgründen ausscheidet. Besonders problematisch bei der Verwendung von Kaufmannionenquellen ist die Korrosion und das Absputtern der Glühkathode.

Im Stand der Technik sind Ionenstrahlanlagen bekannt, die sogenannte Ionenoptiken verwenden. Bisherige Ionenoptiken für großflächige Ionenstrahlen sind jedoch auf die Extraktion und die Beschleunigung von Ionen aus dem Plasma begrenzt. Es ist mit diesen bekannten Ionenoptiken nicht möglich, einen großflächigen Ionenstrahl abzulenken, ohne die Homogenität des Ionenstrahls zu beeinträchtigen und ohne eine zusätzliche Kontaminationsquelle in den Ionenstrahl einzubringen. Da die bisherigen Gitter oder Ablenkeinrichtungen aus Metall oder Graphit bestehen, wird durch Ionenstrahlzerstäubung Material abgetragen, welches die Halbleiterproben kontaminiert. Ein weiteres Problem bei den bisherigen Gittern besteht darin, daß die Gitterstruktur auf der Prozeßscheibe abgebildet wird. Extraktionsgitter sind beispielsweise in der DE 4315348 A1 und in der DE 3601632 A1 beschrieben.

Im Stand der Technik sind Implantationsanlagen bekannt, bei denen eine Ionenquelle vorgesehen ist, die einen Ionenstrahl erzeugt, welcher im Vergleich zur Probe dünn ist. Diese bekannten Implantationsanlagen umfassen neben der Ionenquelle eine Massenseparation, eine Beschleunigungsröhre, eine Ablenk- bzw. Rastereinheit und eine Implantationskammer. Die Massenseparationseinheiten dieser bekannten Ionenimplantationsanlagen bestehen aus einem sogenannten Anlaysemagneten mit einem Vakuumspalt, begrenzt durch die beiden Pole, zwischen denen der von der Ionenquelle abgegebene dünne Ionenstrahl hindurchläuft, wobei durch den Einfluß der Magneten eine Analyse des Ionenstrahls derart erfolgt, daß bestimmte Ionen innerhalb des Ionenstrahls durch die Magnetwirkung stärker aus ihrer Flugbahn abgelenkt werden, so daß diese daran gehindert werden, einen nachfolgend zu der Analyseregion angeordneten Separationsschlitz zu durchlaufen. Auf diese Weise, sind in dem dünnen Ionenstrahl lediglich die erwünschten Ionen enthalten. Solche Ionenimplantationsanlagen sind beispielsweise in der EP 0405855 A2 und in der US-A-5,396,076 beschrieben.

Der Nachteil dieser bekannten Ionenimplantationsanlagen besteht darin, daß diese nicht dazu geeignet sind, eine großflächige Ionenimplantation herbeizuführen, so daß auf eine aufwendige Rasterung der Proben bei diesen bekannten Implantationsanlagen nicht verzichtet werden kann. Ferner ermöglichen diese bekannten Implantationsanlagen auch nicht die Erzeugung eines großflächigen Ionenstrahls und sehen daher auch keine Möglichkeit einer Ablenkung eines solchen großflächigen Ionenstrahls sowie eine Massenseparation eines solchen großflächigen Ionenstrahls vor. Ein weiterer Nachteil dieser bekannten Ionenimplantationsanlagen besteht darin, daß diese einen aufwendigen Aufbau haben, bei dem gegenüberliegend zwei Magnetpole zur Beeinflussung des zwischen diesen Polen hindurchlaufenden Ionenstrahls vorzusehen sind. Ferner ist am Ausgang der Separationseinheit eine Schlitzstruktur vorzusehen, die den erwünschten Ionenstrahl durchläßt. Der Separationsmagnet ist bei Produktionsanlagen mehrere Tonnen schwer und läßt somit kein kompaktes und modernes Anlagenkonzept zu, z.B. Mehrkammerprozeßanlagen.

Ausgehend von diesem Stand der Technik liegt der vorliegenden Erfindung die Aufgabe zugrunde, eine Vorrichtung zur großflächigen Implantation von Ionen und eine Ionenstrahlanlage zu schaffen, bei der Kontaminationen der Prozeßscheibe sicher vermieden werden können, die eine großflächige Ionenimplantation von Proben ermöglicht und die Nachteile, die der direkten Anordnung des Plasmas über der Prozeßscheibe zugeordnet sind, sicher vermeidet.

Diese Aufgabe wird durch eine Vorrichtung gemäß Anspruch 1 und durch eine Ionenstrahlanlage gemäß Anspruch 11 gelöst.

Die vorliegende Erfindung schafft eine Vorrichtung zur großflächigen Implantation von Ionen in eine Probe, mit einer Anode, einer Kathode, die aus demselben Material, aus dem die Probe besteht, zu der Ionen aus der Ionenquelle abgegeben werden, oder aus einem Material hergestellt ist, das für die Probe keine Kontamination darstellt, und einem zwischen der Anode und der Kathode angeordneten, geschlossenen Plasmaraum, wobei die Kathode eine Multischlitzstruktur mit nebeneinanderliegenden Schlitzen, die durch Stege getrennt sind, umfaßt, die von den Ionen durchlaufen wird, und so ein Multibandstrahl erzeugt wird, und wobei an die Kathode oder an nachfolgende Multischlitzstrukturen zur Extraktion und Beschleunigung des Multibandstrahls eine Spannung zur Erzeugung eines senkrecht zum Ionenstrahl liegenden elektrischen Feldes derart anlegbar ist, daß die Stege unterschiedliche Polaritäten aufweisen.

Der Vorteil der vorliegenden Erfindung besteht darin, daß mittels der neuartigen Ionenstrahlanlage ein kontaminationsfreier Ionenstrahl erzeugt, extrahiert, abgelenkt und beschleunigt werden kann, wobei die für die Erzeugung, Extrahierung, Ablenkung und Beschleunigung wesentlichen Elemente der Vorrichtung zur großflächigen Implantation Von Ionen, die in der folgenden Beschreibung auch als Ionenquelle bezeichnet wird, und der Ionenoptik gemäß einem bevorzugten Ausführungsbeispiel aus Silizium bestehen und deshalb für sehr saubere Prozesse in der Siliziumhalbleitertechnologie geeignet sind.

Ein weiterer Vorteil der vorliegenden Erfindung besteht darin, daß mittels der erfindungsgemäßen Ionenstrahlanlage die oben beschriebenen Nachteile der bekannten Implantationsanlagen reduziert bzw. vollständig ausgeräumt werden und ferner ein kostengünstiges, kompaktes und integrierbares System mit hohem Durchsatz und niedrigen Betriebskosten geschaffen wird, das speziell für die Implantation von hohen Dosen bei niedriger Energie, kleiner als 10 keV, geeignet ist.

Ein weiterer Vorteil besteht darin, daß mittels der neuartigen Ionenoptik, die beispielsweise aus Silizium besteht, der Ionenstrahl kontaminationsfrei extrahiert, beschleunigt und/oder abgelenkt werden kann, ohne daß sich eine Gitterstruktur auf der Prozeßscheibe abbildet. Ferner kann die Form des Ionenstrahls dem Substrat bzw. der Prozeßscheibe angepaßt werden, wobei die Größe hierbei beliebig ist. Somit eignet sich die erfindungsgemäße Vorrichtung auch für die Prozessierung von quadratischen Substraten, wie z.B. für LCD-Anzeigen.

Ein weiterer Vorteil der erfindungsgemäßen Ionenstrahlanlage besteht darin, daß es nun möglich ist, die Vorteile der Plasmadotierung mit den Vorteilen der herkömmlichen Ionenimplantation zu verbinden. Es wird ein modernes, leistungsfähiges Halbleiterfertigungsgerät geschaffen, das den Anforderungen in der Ionenimplantationstechnik nach immer höherem Durchsatz bei niedriger Energie und hoher Dosis gerecht wird.

Ein weiterer Vorteil der vorliegenden Erfindung besteht darin, daß ein sehr sauberes Plasma und somit ein kontaminationsfreier Ionenstrahl erzeugt wird, da der Plasmaraum z.B. vollständig mit Quarzglas und Silizium abgeschirmt ist. Ferner wird eine optimale Hochfrequenzeinkopplung sichergestellt, da sich die Elektroden unmittelbar am Plasma befinden und den Plasmaraum abgrenzen.

Wiederum ein weiterer Vorteil besteht darin, daß ein sehr homogenes Plasma auch bei großen Flächen erzeugt werden kann, wobei im Gegensatz zu anderen Plasmaquellen die Homogenität mit steigender Fläche bei einem Parallelplatten-Reaktor zunimmt.

Ein weiterer Vorteil besteht darin, daß die Form des Ionenstrahls beliebig ist und somit der Form der zu bearbeitenden Probe angepaßt werden kann. Ferner wird eine kontaminationsfreie Auskopplung der Ionen aus dem Plasma durch Verwendung eines Siliziumgitters oder eines Siliziumschlitzgitters sichergestellt. Durch sogenanntes Wobbeln bzw. Ablenken des Ionenstrahls wird die Abbildung der Gitter auf den Prozeßscheiben verhindert.

Ein weiterer Vorteil der vorliegenden Erfindung besteht in der Schaffung eines kostengünstigen, kompakten und integrierbaren Systems, das geringe Anschaffungs-, Wartungs- und Betriebskosten hat.

Ferner hat die erfindungsgemäße Ionenstrahlanlage den Vorteil eines hohen Durchsatzes und niedriger Prozeßkosten, wohingegen es bei herkömmlichen Implantationsanlagen bei der Herstellung von flachen pn-Übergängen aufgrund der niedrigen Ionenenergie zu einer drastischen Reduzierung des Ionenstromes und somit zu einem niedrigen Durchsatz kommt. Der Vorteil der vorliegenden Erfindung besteht darin, daß mittels der neuen Vorrichtung es ermöglicht wird, sehr kurze Implantationszeiten bei hohen Dosen zu erreichen.

Wiederum ein weiterer Vorteil der vorliegenden erfindungsgemäßen Ionenstrahlanlage besteht darin, daß ein Implantationsmodul geschaffen wird, das vollständig neue technologische Möglichkeiten bietet, wie z.B. die Durchführung mehrerer Prozeßschritte in einer Anlage, wenn das Implantationsmodul beispielsweise mit einem Tempermodul kombiniert wird.

Ein weiterer Vorteil der erfindungsgemäßen Vorrichtung besteht darin, daß diese für Anwendungen, die einen großflächigen Ionenstrahl erfordern, der direkt (ohne Massenseparation, Ablenk- und Fokusiereinheit) auf die Probe zu beschleunigen ist, besonders gut geeignet ist.

Ein weiterer Vorteil der erfindungsgemäßen Ionenstrahlanlage besteht darin, daß es nun möglich ist, die Vorteile der Plasmadotierung mit den Vorteilen der herkömmlichen Ionenimplantation zu verbinden. Es wird ein modernes, leistungsfähiges Halbleiterfertigungsgerät geschaffen, das den Anforderungen in der Ionenimplantationstechnik nach immer höherem Durchsatz bei niedriger Energie und hoher Dosis gerecht wird.

Gemäß einer bevorzugten Weiterbildung der vorliegenden Erfindung wird eine Vorrichtung geschaffen, bei der die Multischlitzstruktur der Kathode und/ oder die nachfolgenden Multischlitzstrukturen durch parallel zueinander angeordnete Platten gebildet sind, an die ein elektrisches Wechselfeld anlegbar ist.

Gemäß einer Weiterbildung ist an dem der Probe zugewandten Ende der Multischlitzstruktur der Kathode oder der nachfolgenden Multischlitzstrukturen eine Multischlitzgitterstruktur derart angeordnet, daß deren Stege im Strahlengang des Ionenstrahls liegen. Dies ist dann erforderlich, wenn schwere Ionen (z.B. $Ar^+$) von leichten Ionen (z.B. $B^+$) getrennt werden sollen.

Weitere bevorzugte Ausgestaltungen der Erfindung sind in den Unteransprüchen definiert.

Nachfolgend werden anhand der beiliegenden Zeichnungen bevorzugte Ausführungsbeispiele der vorliegenden Erfindung näher beschrieben. Es zeigen:

Fig. 1          ein erstes Ausführungsbeispiel der erfindungsgemäßen Vorrichtung zur großflächigen Implantation von Ionen;

Fig. 2          eine Mehrfach-Schlitzgitterstruktur;

Fig. 3          eine Mehrfach-Schlitzgitterkammstruktur;

Fig. 4          eine schematische Darstellung der Ablenkung von Ionenstrahlen mittels einer Ionenoptik;

Fig. 5a und 5b     ein bevorzugtes Ausführungsbeispiel der erfindungsgemäßen Ionenstrahlanlage;

Fig. 6     ein bevorzugtes Ausführungsbeispiel eines integrierten Dosismeßsystems in der erfindungsgemäßen Ionenstrahlanlage; und

Fig. 7     eine HF-Plasmaquelle gemäß dem Stand der Technik;

Fig. 8a     eine Draufsichtdarstellung eines erfindungsgemäßen MultiPlattensystems gemäß einem weiteren Ausführungsbeispiel der vorliegenden Erfindung;

Fig. 8b     eine Seitenansicht des Multi- Plattensystems aus Fig. 8a; und

Fig. 8c     eine vergrößerte Darstellung der Seitenansicht aus Figur 8b.

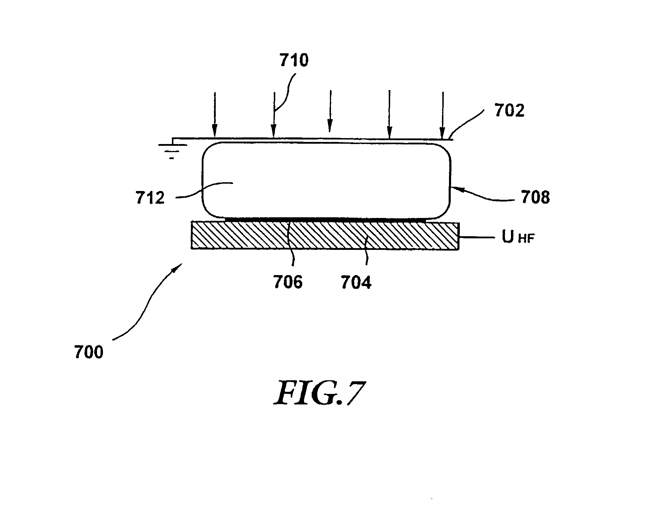

Bevor nachfolgend bevorzugte Ausführungsbeispiele der vorliegenden Erfindung näher beschrieben werden, erfolgt zunächst eine kurze Beschreibung einer herkömmlichen HF-Plasmaquelle für Ätzanwendungen anhand der Fig. 7, wie sie z.B aus der JP-A-2-20018 bekannt ist.

In Fig. 7 ist eine herkömmliche Plasmaquelle in ihrer Gesamtheit mit dem Bezugszeichen 700 bezeichnet. Die HF-Plasmaquelle umfaßt eine sogenannte Duschelektrode 702, die mit Masse verbunden ist. Die Gegenelektrode ist durch den Probenhalter 704 gebildet, auf dem eine zu bearbeitende Probe 706 angeordnet ist. Zwischen der Elektrode 704 und der Duschelektrode 702 ist der sogenannte Plasmaraum 708 definiert. In dem Plasmaraum 708 wird durch Beschicken desselben mit einem Gas, wie es durch die Pfeile 710 angedeutet ist und durch Anlegen einer Hochfrequenzspannung an den Probenhalter 704 ein Plasma 712 erzeugt.

Die in Fig. 7 dargestellte HF-Plasmaquelle stellt eine einfache Art dar, ein sehr homogenes Plasma zu erzeugen. Dies wird durch Anlegen der Hochfrequenzspannung $U_{HF}$ zwischen der Duschelektrode 702 und der Elektrode 704 erreicht. Dieses Prinzip findet vielfach in Ätzmodulen Verwendung, wobei die zu ätzende Siliziumscheibe 706 bereits auf einer Metallplattenelektrode 704 aufliegt. Da das Plasma 712 direkt über der Siliziumscheibe 706 ausgebildet ist und die beiden Plattenelektroden 702 (Duschelektrode in Fig. 7) und 704 aus Metall bestehen, treten in einem solchen System Strahlenschäden und eine Metallkontamination an der Oberfläche der Siliziumscheibe auf. Diese Art der Plasmaerzeugung kann daher nur für Ätzanwendungen oder plasmaunterstützte Schichtabscheidungen verwendet werden.

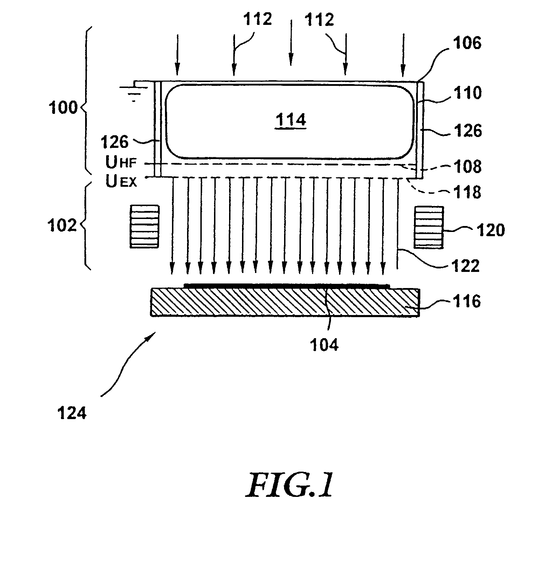

Anhand der Fig. 1 wird nachfolgend ein erstes bevorzugtes Ausführungsbeispiel einer Ionenoptik im Zusammenwirken mit einer Vorrichtung gemäß der vorliegenden Erfindung näher beschrieben. Es wird darauf hingewiesen, daß in der nachfolgenden Beschreibung der vorliegenden Erfindung in den Zeichnungen für ähnliche Elemente die gleichen Bezugszeichen verwendet werden.

In Fig. 1 ist die erfindungsgemäße Vorrichtung bzw. Ionenquelle in ihrer Gesamtheit mit dem Bezugszeichen 100 bezeichnet. Es wird darauf hingewiesen, daß in Fig. 1 neben der erfindungsgemäßen Ionenquelle 100 noch weitere Elemente einer Ionenstrahlanlage dargestellt sind, wie z.B. eine Ionenoptik 102, die zum Extrahieren und/oder Ablenken von aus der Ionenquelle 100 zu einer Probe 104 abgegebenen Ionen dient. Wie es in Fig. 1 dargestellt ist, umfaßt die erfindungsgemäße Ionenquelle 100 eine Anode 106, die mit Masse verbunden ist und eine Kathode 108, an die eine HF-Spannung $U_{HF}$ anlegbar ist. Zwischen der Anode 106 und der Kathode 108 ist ein Plasmaraum 110 definiert. Beim Betrieb der erfindungsgemäßen Ionenquelle wird ein zu ionisierendes Gas in den Plasmaraum 110 eingeleitet, wie dies durch die Pfeile 112 in Fig. 1 dargestellt ist. Aufgrund der Art der Einführung des Gases in den Plasmaraum 110 wird die Anode 106 auch als Duschelektrode bezeichnet. Ebenfalls ist es möglich, den Gaseinlaß von der Anode zu trennen, z.B. durch einen ringförmigen Gaseinlaß zwischen der Anode und der Seitenwand 126. Zur Erzeugung eines Plasmas 114 innerhalb des Plasmaraums 110 wird an die Kathode 108, die beispielsweise als Gitterelektrode ausgebildet ist, eine Hochspannung $U_{HF}$ angelegt.

Wie aus der obigen Beschreibung der erfindungsgemäßen Ionenquelle deutlich wird, weist diese einen sogenannten Parallelplattenreaktor auf, der die nachfolgend näher beschriebenen entscheidenden Ergänzungen aufweist. Die Anode und Kathode, d.h. die Elektroden 106, 108 bestehen gemäß der vorliegenden Erfindung nicht aus einem Metall, sondern aus demselben Material, aus dem die Probe 104 besteht. Gemäß dem in Fig. 1 dargestellten Ausführungsbeispiel bestehen die Elektroden 106, 108 aus einem Halbleitermaterial, wobei die unterste Elektrode 108 beispielsweise in der Form eines Gitters ausgebildet ist oder eine geeignet geformte Lochstruktur aufweist oder aus einer Siliziumplatte mit mehreren Schlitzen besteht. Die Elektrode 108 kann gleichzeitig zu der Erzeugung des Plasmas auch die Extraktion der Ionen aus dem Plasmaraum 110 ermöglichen. Wie es aus Fig. 1 zu erkennen ist, brennt das Plasma 114 nicht direkt über der Probe 104, sondern ist von dieser beabstandet. Durch die Verwendung der Gitterelektrode 108 (bzw. der Schlitzelektrode) wird aus dem Parallelplattenreaktor eine Ionenquelle.

Wie es in Fig. 1 dargestellt ist, ist zwischen der Ionenquelle 100 und der Probe 104 die auf einem Probenhalter 116 angeordnet ist, die Ionenoptik 102 angeordnet. Die Ionenoptik 102 umfaßt ein Extraktionsgitter 118 und eine Ionenablenkeinrichtung 120, die die von der Ionenquelle 100 erzeugten Ionen, die zu der Probe 104 abgegeben werden, extrahieren und ablenken, wie dies durch die Ionenstrahlen 122 in Fig. 1 angedeutet ist.

An die Extraktionselektrode 118 ist eine Extraktionsspannung $U_{EX}$ anlegbar. Es wird darauf hingewiesen, daß die Elektrode 118 beispielsweise als Gitter oder Schlitzelektrode ausgebildet sein kann. Mittels der Ablenkeinrichtung 120 erfolgt eine Ablenkung der Ionenstrahlen 122. Die Funktionsweise der Ionenoptik 102 wird später noch detaillierter beschrieben. Die Kombination der in Fig. 1 dargestellten zwei Hauptkomponenten, nämlich der Ionenquelle 100 und der erfindungsgemäßen Ionenoptik 102 stellt ein Ausführungsbeispiel einer Ionenstrahlanlage 124 dar.

Es wird jedoch darauf hingewiesen, daß abhängig von der vorgesehen Verwendung der Ionenquelle 100 auf die Ionenoptik 102 ganz oder teilweise verzichtet werden kann. Mit anderen Worten ist es beispielsweise nicht zwingend erforderlich, das in Fig. 1 dargestellte Extraktionsgitter 118 und die Ionenablenkeinrichtung 120, die beispielsweise auch in der Form eines Gitters vorliegt, vorzusehen, da einerseits die im Plasma 114 zwischen der oberen und der unteren Elektrode 106, 108 entstehende Spannung zur Ionenextraktion verwendet werden kann, und andererseits eine Spannung zwischen der Gitterelektrode 108 und dem Probenhalter 116 zur Extraktion anlegbar ist.

Ferner ist es möglich, auch nur einen Teil der Ionenoptik zusammen mit der Ionenquelle 100 vorzusehen, abhängig vom Anwendungsfall. So kann beispielsweise auf die Ionenablenkeinrichtung 120 verzichtet werden und nur ein Extraktionsgitter 118 vorgesehen sein. Andererseits kann, wenn die Extraktionsspannung auf die oben beschriebene Art erzeugt wird, auf das Extraktionsgitter 118 verzichtet werden, und nur die Ablenkeinrichtung 120 vorgesehen sein.

Neben den oben beschriebenen Strukturen der Kathode 108 kann diese auch eine Mehrfach-Schlitzstruktur haben.

Wie es in Fig. 1 weiter dargestellt ist, ist der Plasmaraum 110 in Bereichen, in denen er nicht durch die Anode 106 oder die Kathode 108 begrenzt ist, durch eine nicht-metallische Struktur 126 begrenzt, die beispielsweise eine Quarzstruktur ist.

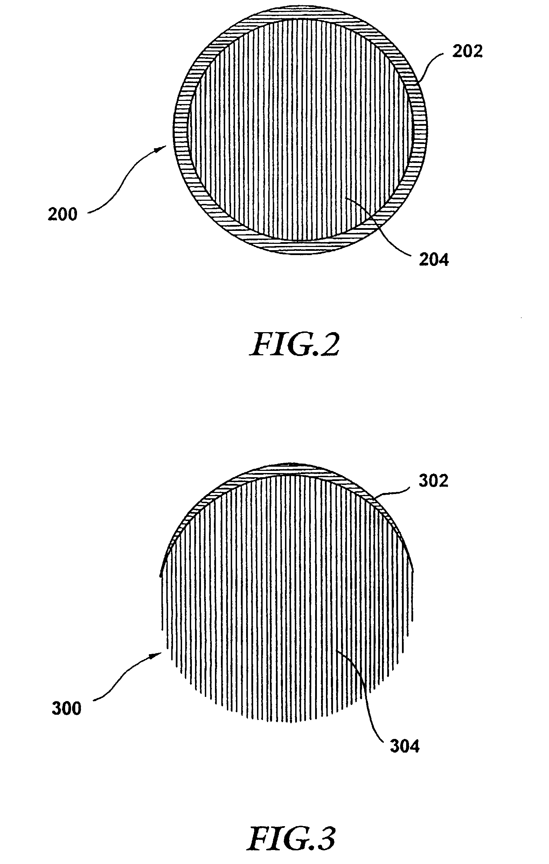

Nachfolgend wird anhand der Fig. 2 bis 4 die oben angesprochene Ionenoptik 102 näher beschrieben. Wie es bereits im Vorhergehenden ausgeführt wurde, sind die bisher bekannten Ionenoptiken für großflächige Ionenstrahlen einfache Metall- oder Graphitgitter, mit denen nur eine Extraktion und Beschleunigung der Ionen möglich ist. Diese Gittersysteme haben zwei entscheidende Nachteile für die Anwendung bei der Ionenimplantation, erstens sind sie eine Kontaminationsquelle, zweitens werfen sie einen Schatten, d.h. die Gitter werden durch den Ionenstrahl auf der zu implantierenden Probe abgebildet.

Wie es bereits anhand der Fig. 1 kurz beschrieben wurde, umfaßt die Ionenoptik 102 eine Einrichtung 118, 120, mittels der Ionen, die aus der Ionenquelle 100 zu der Probe 104 abgegeben werden, extrahiert und/ oder abgelenkt werden. Abhängig von der erwünschten Anwendung kann hierbei entweder nur extrahiert oder nur abgelenkt oder extrahiert und abgelenkt werden.

In Fig. 2 und 3 sind bevorzugte Ausführungsbeispiele der verwendeten Gitterstrukturen 200 bzw. 300 dargestellt. Die Ionenoptik 102 (Fig. 1) umfaßt eine Extraktionseinrichtung 118 und eine Ionenablenkeinrichtung 120. Die Extraktionseinrichtung ist durch eine Mehrfach-Schlitzgitterstruktur 200 (Fig. 2) gebildet. Die Gitterstruktur 200 umfaßt einen soliden Umfangsabschnitt 202 sowie eine Mehrzahl von leitfähigen Stegen 204, die von dem Umfangsabschnitt 202 gehalten sind. Der Umfangsabschnitt 202 ist bevorzugterweise aus einem isolierenden Material hergestellt, um somit die voneinander isolierte Anordnung mehrerer Strukturen 200 zu ermöglichen. Ferner ist die Gitterstruktur 200 mit einer Anschlußvorrichtung, die in Fig. 2 nicht dargestellt ist, versehen, um das Anlegen einer Spannung an die Stege 204 zu ermöglichen.

Die Ionenablenkeinrichtung der Ionenoptik 102 ist durch eine Mehrzahl von Mehrfach-Schlitzgitterstrukturen gebildet, die voneinander isoliert sind. Die Mehrfach-Schlitzgitterstruktur für die Ionenablenkeinrichtung 120 kann beispielsweise durch eine Mehrzahl von übereinander angeordneten Mehrfach-Schlitzgitterstrukturen gebildet sein, wie sie in Fig. 2 dargestellt ist.

Gemäß einem weiteren Ausführungsbeispiel ist eine Mehrfach-Schlitzgitterstruktur als Kammstruktur ausgebildet, wie dies in Fig. 3 dargestellt ist. Die in Fig. 3 dargestellte Mehrfach-Schlitzgitterstruktur 300 umfaßt einen Umfangsabschnitt 302, der sich teilweise um den äußeren Umfang der Struktur 300 erstreckt. Ausgehend von dem Umfangsabschnitt 302 erstrecken sich Stege 304, die voneinander beabstandet sind und mit dem Umfangsabschnitt verbunden sind. Die Stege können durch eine geeignete Vorrichtung mit einer Spannungsquelle (nicht dargestellt) verbunden werden. Bei der Verwendung einer Gitterstruktur, wie sie in Fig. 3 dargestellt ist, umfaßt die Ionenablenkeinrichtung 120 eine Mehrzahl von Mehrfach-Schlitzgitter-Kammstrukturen, wobei diese derart angeordnet sind, daß die Kammstrukturen (in der Form der Stege 304) ineinander geschoben sind.

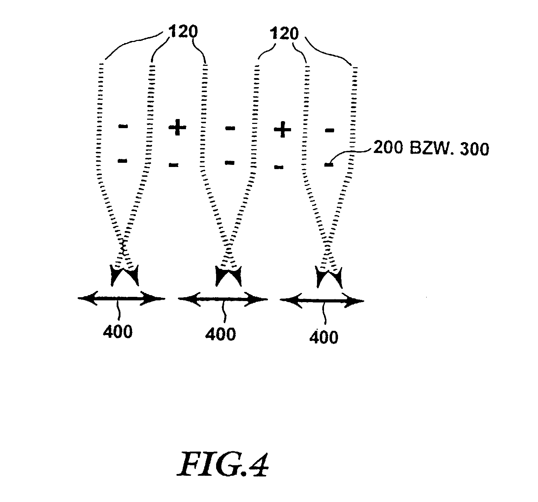

Die wesentlichen Elemente der Ionenoptik, die zur Extraktion und/oder Ablenkung des Ionenstrahls 120 vorgesehen sind, bestehen gemäß der vorliegenden Erfindung aus demselben Material, aus dem die Probe 104 besteht. Die Verwendung der Mehrfachschlitz-Ionenoptik, beispielsweise aus Silizium, wenn eine Siliziumprobe zu behandeln ist, hat den Vorteil, daß die Ionenoptik 120 für die Prozeßscheibe bzw. Probe 104 keine Kontaminationsquelle darstellt, da beide aus demselben Material bestehen. Das von Ionenstrahl zerstäubte Material ist beispielsweise Silizium. Durch Verwendung eines Mehrfach-Schlitzsystems können die Ionen extrahiert, beschleunigt und/oder abgelenkt werden. Hierbei werden zwei übereinander gelegte und voneinander isolierte Mehrfach-Schlitzscheiben 200 oder zwei ineinander geschobene Kammstrukturen 300 verwendet, wodurch es ermöglicht wird, ein elektrisches Feld senkrecht zur Ionenstrahlrichtung zu erzeugen und dadurch einen großflächigen Ionenstrahl abzulenken, ohne dessen Homogenität zu beeinträchtigen. Dies ist in Fig. 4 verdeutlicht, in der positive Ionenstrahlen 120 dargestellt sind, die eine ineinandergeschobene Kammstruktur 300 bzw. übereinander angeordnete flache Schlitzgitter 200 durchlaufen. Durch Erzeugung des elektrischen Feldes senkrecht zur Ionenstrahlrichtung, wie es durch die Angaben der Polarität vereinfacht dargestellt ist, erfolgt eine Auslenkung der Ionenstrahlen, wie es durch die Pfeile 400 dargestellt ist. Die Ionenoptik stellt somit eine Art Breitstrahlwobbeleinrichtung, im vorliegenden Fall beispielsweise eine Siliziumbreitstrahl-Wobbeleinrichtung dar, mit der auf einfache Weise das Abbilden der Gitterstruktur 200 bzw. 300 (Extraktionsgitter, Beschleunigungsgitter) auf die Siliziumprozeßscheibe 104 verhindert wird.

Ein Vorteil der oben beschriebenen Ionenoptik besteht darin, daß diese gegenüber thermischer Ausdehnung unempfindlich ist, und somit keine mechanischen Spannungen auftreten und eine Dejustierung vermieden wird.

Ein weiterer Vorteil ist die einfache Herstellung der Strukturen 200 bzw. 300, die nach deren Strukturierung mit Hilfe einer Diamantsäge zu entsprechenden Scheiben mit vorbestimmter Dicke erzeugt werden.

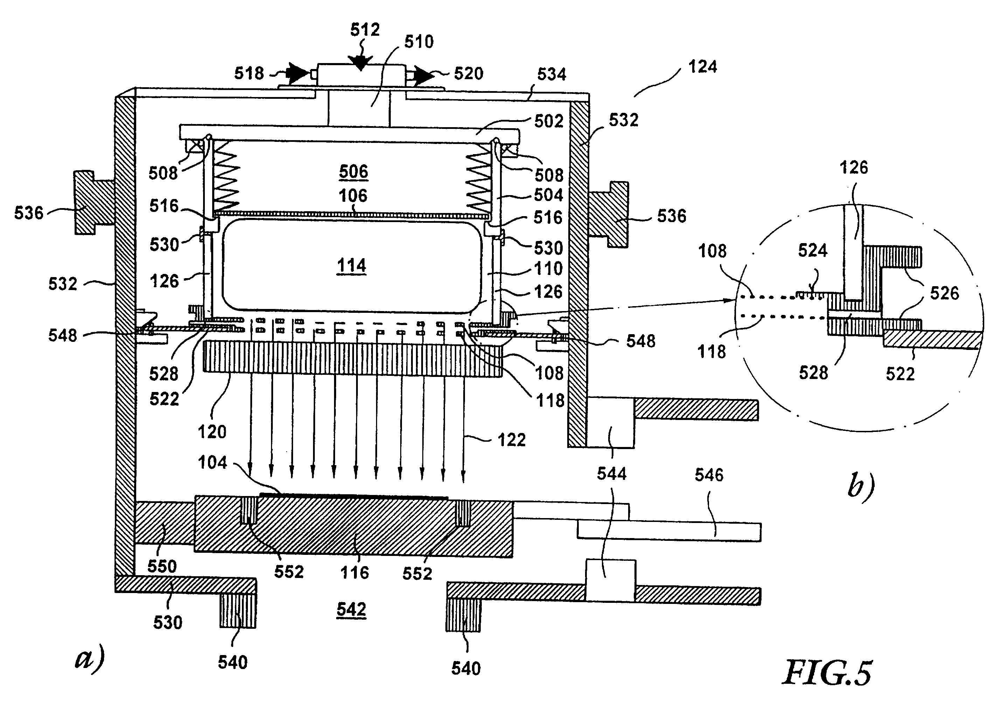

Nachfolgend wird anhand der Fig. 5a und der Fig. 5b ein weiteres bevorzugtes Ausführungsbeispiel der erfindungsgemäßen Ionenstrahlanlage 124 beschrieben, wobei in Fig. 5 Elemente, die bereits anhand der vorhergehenden Figuren beschrieben wurden, mit gleichen Bezugszeichen versehen sind und eine erneute Beschreibung weggelassen ist.

Bei der in Fig. 5 dargestellten Ionenstrahlanlage 124 bildet sich das Plasma 114 gemäß dem in Fig. 5 dargestellten Ausführungsbeispiel im Bereich zwischen einer Siliziumanode 106 und einer Siliziumschlitzkathode 108 aus, wobei der Plasmaraum 110 nach außen durch Quarzringe 126 abgeschirmt ist. Das Plasma 114 kommt somit nur noch mit Silizium bzw. Quarzoberflächen in Berührung, was eine Metallkontamination verhindert. Durch Anlegen einer negativen externen Gleichspannung an das Siliziumextraktionsgitter 118 werden positive Plasmaionen extrahiert und auf die zu prozessierenden Scheiben 104 beschleunigt. Durch eine Siliziumionenoptik 120 wird der Strahl abgelenkt, und kann beispielsweise durch eine zusätzliche, nicht dargestellte Lochblende fokusiert bzw. defokusiert werden.

Die Siliziumanode 106, die auch als Duschanode bezeichnet wird, umfaßt eine Metallhalterung 502, und eine Quarzringhalterung 504, wobei durch die Anode 106, die Metallhalterung 502 und die Quarzringhalterung 504 ein geschlossener Gasverteilungsraum 506 definiert ist.

An den Verbindungsstellen zwischen der Metallhalterung 502 und der Quarzringhalterung 504 sind entsprechende Dichtungselemente 508 angeordnet, um den Gasverteilungsraum 506 dicht abzuschließen. Über einen Gaseinlaß 510 wird Gas von einer Gasversorgung 512 in den Gasverteilungsraum 506 eingebracht. Der Gasverteilungsraum 506 gewährleistet eine optimale Gasverteilung und stellt ferner eine physikalische Trennung der Metallhalterung zu der Siliziumanode 106 sicher, so daß eine vollständige Trennung des Plasmas 114 von Metallteilen gewährleistet ist. Wie es in Fig. 5 zu erkennen ist, ist die Anode 106 durch Wolframfedern 514 an der Metallhalterung 502 befestigt und gegen einen Vorsprung 516 der Quarzringhalterung 504 vorgespannt.

Das Gas wird aus dem Gasverteilungsraum 506 in den Plasmaraum 510 durch eine Mehrzahl von gleichmäßig verteilten Löchern in der Siliziumscheibe 106 oder ringförmig am Rande zwischen dem Vorsprung 516 und der Siliziumscheibe 106 eingebracht. Die Metallhalterung 502 und die Siliziumanode 106 sind beide geerdet.

Die Metallhalterung 502 ist mit einem Wassereinlaß 518 und mit einem Wasserauslaß 520 verbunden, wodurch eine Wasserkühlung der Metallhalterung 502 bereitgestellt wird.

Die Siliziumkathodenanordnung ruht auf einem Glasring 522, der als Grundplatte und zur elektrischen Isolation dient. Ferner ist ein Siliziumring vorgesehen, der Aluminiumkontaktringe 526 und 527 von dem Plasmaraum 110 isoliert. Die Aluminiumkontaktringe 526 dienen dazu, die entsprechenden Spannungen an die Elektroden 108 und 118 anzulegen, wie dies in Fig. 5b zu erkennen ist. Um einen Kurzschluß zwischen den Elektroden 108 und 118 zu vermeiden, sind diese durch einen Teflonring 528 voneinander isoliert.

Wie es in Fig. 5 zu sehen ist, ist die Anodenstruktur mit der Kathodenstruktur über die Quarzglasringseitenteile 126 verbunden, wobei bei aufgesetzter Anodenstruktur die Quarzringhalterung 504 zusammen mit einer Teflondichtung 530 und dem Quarzglasringseitenteil 126 den Plasmaraum 110 nach außen vollständig abschirmen.

Die erforderliche Hochfrequenzspannung wird über den Aluminiumkontakt 526 an die Siliziumkathode 108 angelegt.

Der erzeugte Ionenstrahl 122 wird durch die bereits oben beschriebene Ionenoptik 120 abgelenkt bzw. gewobbelt, so daß sich keine Gitterstrukturen auf der Siliziumscheibe 104 abbilden. Zusätzlich kann eine in Fig. 5 nicht dargestellte Lochapertur vorgesehen sein, die den Ionenstrahl geringfügig verbreitert bzw. fokusiert. Durch das Anlegen einer Spannung an ein weiteres, ebenfalls nicht dargestelltes Schlitzgitter, bzw. an die Probenhalterung 116 wird der Ionenstrahl auf die gewünschte Energie gebracht, so daß die Beschleunigungsspannung von der Extraktionsspannung entkoppelt ist und in weiten Bereichen frei gewählt werden kann. Die Probenhalterung 116 ist in diesem Ausführungsbeispiel mit Silizium verkleidet, um Kontaminationen durch eine Zerstäubung zu vermeiden.

Die bisher beschriebene Anordnung ist in einem Vakuumgehäuse angeordnet, das wassergekühlte Seitenwände 532 sowie einen Vakuumdeckel 534 aufweist. Die Seitenwände sind mit Flanschen 536 versehen, die als Sichtfenster, Spannungs- und Meßdurchführung genutzt werden können.

Ein Boden 538 des Gehäuses umfaßt zwei Flansche 540, zwischen denen eine Ausnehmung 542 gebildet ist, die den Anschluß des Gehäuses an eine Vakuumpumpe ermöglichen. An einer Seitenwand 532 des Gehäuses ist ein Vakuumventil 544 vorgesehen, das die Beschickung der Ionenstrahlanlage mit einer zu prozessierenden Scheibe mittels einer Robotereinrichtung 546 ermöglicht. Die Ionenquelle ist mittels des Glasrings 522 über entsprechende Befestigungselemente 548 an der Seitenwand 532 befestigt. Ebenso ist der Probenhalter 116 mittels einer isolierten Aufhängung 550 an dem Gehäuseseitenteil 532 befestigt.

In dem Probenhalter 116 ist eine Mehrzahl von Faraday-Bechern 552 integriert. Mittels dieser Becher 552 kann der Ionenstrom und die Homogenität des Ionenstrahls während des Prozesses gemessen werden. Durch eine Aufintegration des Ionenstroms über die Prozeßzeit ist die Bestimmung der Ionendosis möglich, welche eine wichtige Kenngröße beim Ionenimplantationsprozeß darstellt.

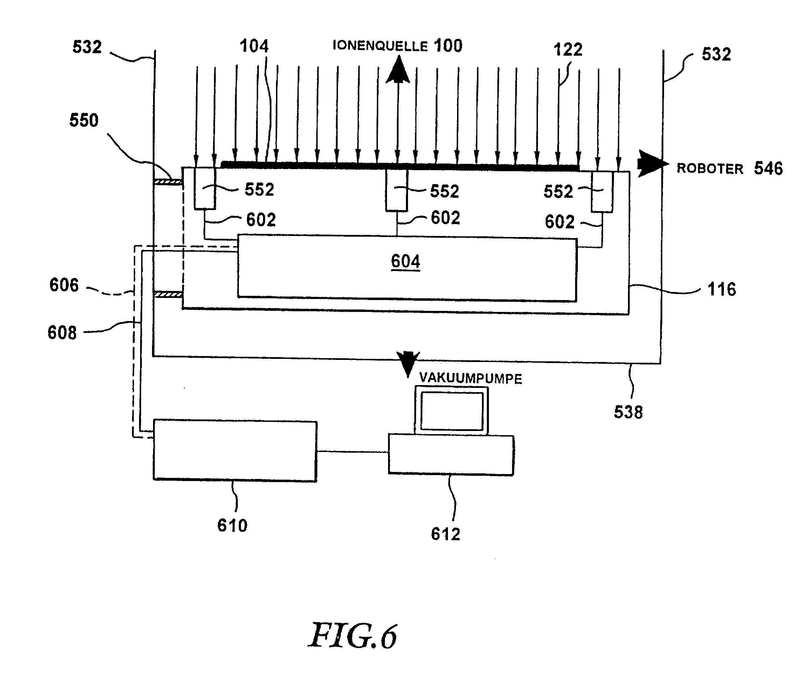

Nachfolgend wird anhand der Fig. 6 eine Dosismeßeinrichtung detaillierter beschrieben. Elemente, die bereits anhand der vorhergehenden Figuren beschrieben wurden, sind in Fig. 6 mit den gleichen Bezugszeichen versehen und eine detaillierte Beschreibung dieser Elemente wird weggelassen.

Die integrierte Dosismessung erfolgt durch eine Mehrzahl von Faraday-Bechern 552, die in der Prozeßscheibenhalterung 116 angeordnet sind, wie dies in Fig. 6 dargestellt ist. Mittels dieser Faraday-Becher wird der Ionenstrom und die Homogenität des Ionenstrahls während des Prozesses bzw. zwischen den einzelnen Prozeßschritten gemessen. Durch eine Integration des Ionenstroms über die Prozeßzeit ist die Bestimmung der Ionendosis möglich, welche eine wichtige Kenngröße bei einem Ionenimplantationsprozeß darstellt.

Wie es in Fig. 6 dargestellt ist, sind die einzelnen Faraday-Becher 552 über Leitungen 602 mit einem Meßverstärker 604 verbunden, der innerhalb der Halterung 116 angeordnet ist. Über eine Datenleitung 606 und eine Energieleitung 608 ist der Meßverstärker mit einer Dosismeßeinrichtung 610 verbunden. Die Dosismeßeinrichtung umfaßt eine Steuerung, eine Dosisanzeige, eine Energieversorgungseinheit und stellt eine Schnittstelle mit dem Meßstromverstärker und mit einem Steuerrechner 612 bereit. Der Steuerrechner 612 dient neben der Ansteuerung des Dosismeßgeräts auch zur Steuerung der in Fig. 5 dargestellten Ionenstrahlanlage.

Wie es in Fig. 6 zu sehen ist, erfolgt die Verbindung zwischen Meßverstärker und Dosismeßgeräten mittels der Leitungen 606 und 608, die durch eine isolierte Durchführung in der Aufhängung 550 geführt sind, mit der die Scheibenhalterung 116 an einer Seitenwand 632 befestigt ist. Das Innere der Scheibenhalterung 116 ist von dem im Inneren des Gehäuses 532 herrschenden Vakuum isoliert.

Der in Fig. 6 dargestellte Stromintegrator besteht aus mehreren Faraday-Meßbechern 552 und einer oder mehrerer Verstärkereinheiten 604 an jedem Faraday-Meßbecher, die auf einem Hochspannungspotential liegt und beide in der Halterung 116 integriert sind. Ein Dosismeßgerät und ein Rechner sind, wie bereits oben beschrieben wurde, vorgesehen.

Das Verstärkersignal wird über einen Lichtwellenleiter zum Dosismeßgerät weitergeleitet und in der Dosissteuerung wird das Signal über die Prozeßzeit integriert und in die Dosis umgerechnet. Nachdem eine voreingestellte Dosis erreicht ist, wird der Implantationsprozeß von der Steuerung über den Steuerrechner 612 abgeschaltet. Die Dosisisteuerung kann manuell oder über den Steuerrechner 612 eingestellt werden. Da mehrere Meßbecher symmetrisch am Rand der Implantationsfläche angeordnet sind, erhält man über die Abweichung der einzelnen Meßwerte während des Prozesses ein Maß für die Homogenität. Bei einem Scheibenwechsel, d.h. wenn der Roboter 546 (Fig. 5) die Scheibe 104 entfernt und eine neue Scheibe holt, ist anhand von einem oder mehreren weiteren Meßbechern, die während des Prozesses von der Siliziumscheibe abgedeckt sind, eine genaue Homogenitätsbestimmung direkt am Ort der Scheibenablage möglich.

Der Vorteil des oben beschriebenen Dosismeßsystems besteht darin, daß die Messung der Dosis direkt an der Siliziumscheibe erfolgt und die Messung der Strahlhomogenität ohne mechanisch bewegte Teile direkt am Ort der Scheibenablage durchgeführt wird. Das beschriebene Dosismeßsystem weist eine hohe Störsicherheit auf, da das Meßsignal direkt nach dem Meßbecher 552 verstärkt wird und erst dann an eine Dosissteuerung weitergeleitet wird.

Ferner hat das System den Vorteil, daß der Faraday-Becher und der Verstärker von der Dosissteuerung galvanisch getrennt sind und somit auf unterschiedlichem Potential liegen können. Dies ermöglicht eine Dosismessung auch dann, wenn der Faraday-Becher auf 20 kV liegt und die Steuerung auf Massepotential liegt.

Obwohl in der vorhergehenden Beschreibung der bevorzugten Ausführungsbeispiele der vorliegenden Erfindung hauptsächlich auf Proben aus Silizium Bezug genommen wurde, wird darauf hingewiesen, daß anstelle des beschriebenen Siliziums auch Proben aus anderem Material, wie z.B. Galiumarsenid oder Germanium oder ähnlichem verwendet werden können, wobei in diesem Fall zur Vermeidung der Kontamination der zu bearbeitenden Prozeßscheibe die oben beschriebenen Elemente der Ionenquelle bzw. der Ionenstrahlanlage aus demselben Material hergestellt sind, aus dem die zu bearbeitende Probe besteht, oder aus einem die Material hergestellt sind, das für die Probe keine Kontamination darstellt, wie z.B. Si oder C bei einer Probe aus SiC.

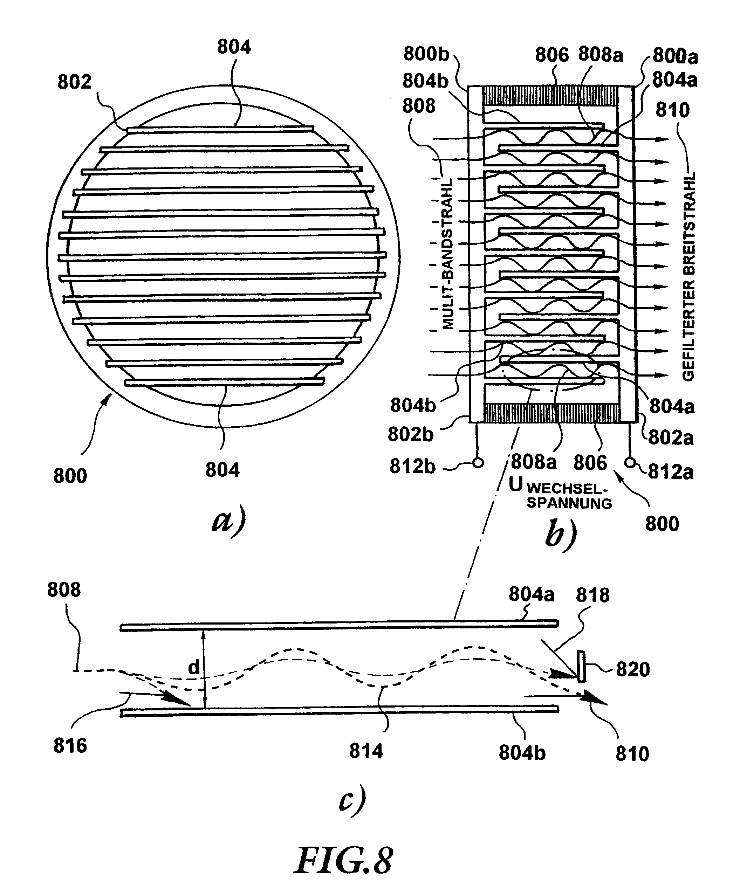

Nachfolgend wird anhand der Figur 8 ein Ausführungsbeispiel einer Komponente eines Multi-Bandstrahlsystems für eine einfache Massenseparation eines großflächigen Ionenstrahls dargestellt.

In der Figur 8a ist eine Multischlitzstruktur 800 dargestellt, die einen Aluminiumkontaktring 802 sowie eine Mehrzahl von parallel zueinander angeordneten Platten 804 umfaßt. Die Platten 804 sind an deren gegenüberliegenden Enden mit dem Aluminiumkontaktring 802 verbunden. Die Platten 804 sind entweder selbst aus einem leitfähigen Material hergestellt oder mit einer leitfähigen Schicht (nicht dargestellt) beschichtet, um das Anlegen eines elektrischen Wechselfeldes zwischen die einzelnen Platten zu ermöglichen. Um Kontaminationen zu vermeiden, sollte, wenn möglich, das Material der Platten gleich sein mit dem Material der zu implantierenden Probe, oder mit diesem beschichtet sein.

In Figur 8b ist eine Seitenansicht des Multi-Plattensystems 800 dargestellt. Wie in Figur 8b zu sehen ist, ist das Multi-Plattensystem 800 gemäß einem bevorzugten Ausführungsbeispiel der vorliegenden Erfindung durch eine erste Teilkomponente 800a und eine zweite Teilkomponente 800b gebildet. Die Teilkomponenten 800a und 800b sind durch Isolatoren 806 voneinander isoliert. Die Isolatoren 806 dienen gleichzeitig dazu, zwischen den Komponenten 800a und 800b einen vorbestimmten Abstand einzustellen. Gemäß einem bevorzugten Ausführungsbeispiel können die Isolatoren bzw. Abstandhalter 806 aus Teflon hergestellt sein.

Wie in Figur 8b zu sehen ist, umfaßt jede der Teilkomponenten 800a und 800b einen Aluminiumkontaktring 802a und 802b, wobei jedoch in diesem Zusammenhang darauf hingewiesen wird, daß die Verwendung eines Aluminiumkontaktrings nicht zwingend ist. Auch andere leitfähige Materialien können verwendet werden. Ferner können die Kontaktstrukturen 802a und 802b auch aus einem nicht leitenden Material hergestellt sein, das entweder ganz oder teilweise mit einer leitfähigen Schicht bedeckt ist. An den Kontaktringen 802a und 802b sind die einzelnen Platten 804a und 804b angeordnet. Wie es bereits oben ausgeführt wurde, können die Platten 804a und 804b entweder aus einem leitfähigen Material oder aus einem nicht leitfähigen Material, welches mit einer leitfähigen Schicht bedeckt ist, gebildet sein. Die Teilkomponenten 800a und 800b sind derart ausgebildet, daß die Platten parallel zueinander angeordnet sind und sich in die gleiche Richtung von den Kontaktringen erstrecken. Hierdurch ergibt sich die Kammstruktur der in Figur 8b dargestellten Teilkomponenten 800a und 800b. Die Teilkomponenten 800a und 800b sind derart zueinander angeordnet, daß die Platten 804a der ersten Teilkomponente 800a zwischen die Platten 804b der zweiten Teilkomponente 800b derart eingeführt sind, daß sich zwischen den nunmehr benachbarten Platten 804a und 804b ein vorbestimmter Abstand einstellt.

Ein Multi-Bandstrahl 808 tritt aus der Ionenquelle in die Anordnung 800 ein und die einzelnen Teilstrahlen 808a laufen zwischen den parallel angeordneten Platten 804b und 804a der beiden Teilkomponenten 800b und 800a hindurch und werden in dem Bereich, in dem die Platten 804a und 804b sich gegenüberliegen von einem an die Einheit 800 angelegten Wechselfeld beeinflußt, so daß sich am Ausgang der Anordnung 800 ein gefilterter Breitstrahl 810 ergibt, der auf die Probe gerichtet ist. Das Wechselfeld zwischen den Platten 804a und 804b wird durch Anlegen einer Wechselspannung an die Anschlüsse 812a der ersten Teilkomponente 800a und 812b der zweiten Teilkomponente 800b erzeugt.

Die in Figur 8b dargestellte kammförmige Struktur der Anordnung 800 stellt lediglich ein bevorzugtes Ausführungsbeispiel der vorliegenden Erfindung dar. Es wird darauf hingewiesen, daß auch andere Ausführungsformen möglich sind, so kann beispielsweise an Stelle der zwei Teilkomponenten 800a und 800b, an die eine elektrische Spannung angelegt wird, nur eine einzige Komponente vorgesehen sein, wobei in diesem Fall zwei Anschlüsse für das Anlegen einer elektrischen Spannung vorhanden sein müssen. Um eine Massenseparation mittels einer solchen Anordnung zu bewirken ist es erforderlich, daß die Platten der Anordnung alternierend einmal mit dem ersten Anschluß und zum anderen Mal mit dem anderen Anschluß zum Anlegen der Wechselspannung verbunden sind und die benachbarten Platten voneinander isoliert angeordnet sind, um zwischen den Platten das erforderliche Wechselfeld zu erzeugen.

Nachfolgend wird anhand der Figur 8c, welche eine vergrößerte Darstellung eines Ausschnitts der Anordnung 800 darstellt, das der vorliegenden Erfindung zugrundeliegende Funktionsprinzip näher erläutert.

In Figur 8c ist eine Platte 804a der ersten Teilkomponente 800a und eine Platte 804b der zweiten Teilkomponente 800b dargestellt, an die ein elektrisches Wechselfeld angelegt ist. Zwischen die Platten 804a und 804b tritt ein Ionenstrahl des Multi-Bandstrahls 808 ein, läuft zwischen den Platten 804a und 804b hindurch und wird dabei durch das elektrische Wechselfeld beeinflußt, so daß am Ausgang der Platten 804a und 804b ein gefilterter Ionenstrahl 810 austritt. Bei dem in Figuren 8b und 8c dargestellten Ausführungsbeispiel sind die Platten 804a und 804b aus Silizium hergestellt, um eine Kontamination einer Siliziumprobe, die mit dem Ionenstrahl 810 zu beaufschlagen ist, durch das Herauslösen von Teilchen aus den Platten zu vermeiden.

Leitet man, wie es in Figur 8c dargestellt ist, einen einzelnen Band- bzw. Ionenstrahl 814 zwischen den voneinander isolierten Platten 804a und 804b hindurch, so kann dieser Band- bzw. Ionenstrahl 814 durch das anliegende elektrische Wechselfeld zwischen den Platten 804a, 804b, was auch als Wobbeln bezeichnet wird, auf Wellenbahnen gezwungen werden.

Die Amplitude der Auslenkung Y des Band-bzw. Ionenstrahles ist abhängig von der Frequenz f der Wechselspannung, von dem Plattenabstand d, von der Amplitude der Wechselspannung $U_0$, und von der Masse m und der Ladung q der Ionen, wie es durch die nachfolgende Gleichung dargestellt ist:

$$Y = \frac{U_0 \cdot q}{d \cdot m \cdot 4 \cdot \pi^2 \cdot f^2}$$

Durch die angelegte Wechselspannung wird ein leichteres Ion 816, beispielsweise H$^+$, stärker abgelenkt als ein schwereres Ion 818, zum Beispiel P$^+$, wie dies in Figur 8c dargestellt ist. Wählt man den Plattenabstand d kleiner als die Auslenkung des leichten Ions und größer als die Auslenkung des schweren Ions, wird das leichte Ion durch Stöße mit den Platten 804a und 804b von dem schweren Ion getrennt. Es ist damit zum Beispiel möglich als Plasmagas $PH_3$ zu verwenden, und den Wasserstoff durch das erfindungsgemäße Multi-Plattensystem herauszufiltern.

Gemäß einem weiteren bevorzugten Ausführungsbeispiel der vorliegenden Erfindung kann am Ausgang des Multi-Plattensystems, daß heißt an dem der Probe zugewandten Ende des Multi-Plattensystems ein Schlitzgitter 820 angeordnet sein. Das Bezugszeichen 820 bezeichnet in Figur 8c einen Steg des Multischlitzgitters, das beispielsweise aus Silizium hergestellt ist. Durch das Anordnen des Silizium-Multischlitzgitters am Ausgang des Multi-Plattensystems und durch Vorsehen einer vordefinierten Stegbreite können auch schwerere Ionen, wie zum Beispiel Ar$^+$, welches oft als Trägergas verwendet wird, von leichteren Ionen, wie zum Beispiel B$^+$ oder P$^+$, getrennt werden, wie dies in Figur 8c beim Bezugszeichen 818 dargestellt ist.

Ein weiterer Vorteil des erfindungsgemäßen Multi-Plattensystems neben der Massenseparation besteht darin, daß im Gegensatz zu einer Struktur, die nur aus einem Multischlitzgitter besteht, das Wobbeln zur Vermeidung von Gitterabbildungen bei niedrigeren Wobbelspannungen möglich ist, da das Ion auf seiner Flugbahn länger dem elektrischen Feld quer zur Flugrichtung ausgesetzt ist.

## Patentansprüche

1. Vorrichtung zur großflächigen Implantation von Ionen in eine Probe (104), mit

    einer Anode (106);

    einer Kathode (108), die aus demselben Material, aus dem die Probe (104) besteht, zu der Ionen aus der Ionenquelle (100) abgegeben werden, hergestellt ist oder mit diesem beschichtet ist, oder aus einem Material hergestellt ist, das für die Probe (104) keine Kontamination darstellt; und

    einem zwischen der Anode (106) und der Kathode (108) angeordneten Plasmaraum (110);

   dadurch gekennzeichnet,

    daß der Plasmaraum geschlossen ist;

    daß die Kathode (108) eine Multischlitzstruktur (200; 300) mit nebeneinanderliegenden Schlitzen, die durch Stege getrennt sind, umfaßt, die von den Ionen durchlaufen wird, und so ein Multibandstrahl erzeugt wird; und

    daß an die Kathode oder an nachfolgende Multischlitzstrukturen zur Extraktion und Beschleunigung des Multi-bandstrahls eine Spannung zur Erzeugung eines senkrecht zum Ionenstrahl liegenden elektrischen Feldes derart anlegbar ist, daß die Stege unterschiedliche Polaritäten aufweisen.

2. Vorrichtung nach Anspruch 1, dadurch gekennzeichnet,
   daß die Multischlitzstruktur der Kathode und/oder die nachfolgenden Multischlitzstrukturen durch eine Mehrzahl von Multischlitzgitterstrukturen (200; 300) gebildet ist, die voneinander isoliert sind.

3. Vorrichtung nach Anspruch 2, dadurch gekennzeichnet,
   daß die Multischlitzstruktur der Kathode und/oder die nachfolgenden Multischlitzstrukturen durch eine Mehrzahl von übereinander angeordneten Multischlitzgitterstrukturen (200) gebildet ist.

4. Vorrichtung nach Anspruch 2, dadurch gekennzeichnet,
   daß die Multischlitzstruktur der Kathode und/oder die nachfolgenden Multischlitzstrukturen eine Mehrzahl von Multischlitzgitterstrukturen umfaßt, die eine Kammstruktur (300) haben, wobei die Multischlitzgitterkammstrukturen (300) ineinandergeschoben sind.

5. Vorrichtung nach einem der Ansprüche 1 bis 4, dadurch gekennzeichnet,
daß die Anode (106) zumindest im Fall von reaktiven Gasen ebenfalls aus demselben Material, aus dem die Probe (104) besteht, oder aus einem Material hergestellt ist, das für die Probe (104) keine Kontamination darstellt.

6. Vorrichtung nach einem der Ansprüche 1 bis 5, dadurch gekennzeichnet,
daß der Plasmaraum (110) in Bereichen, in denen dieser nicht durch die Anode (106) und die Kathode (108) begrenzt ist, durch eine nicht-metallische Struktur (126), wie etwa eine Quarzstruktur, begrenzt ist, wodurch eine zusätzliche induktive Hochfrequenzeinkopplung ermöglicht wird.

7. Vorrichtung nach einem der Ansprüche 1 bis 6, gekennzeichnet durch
einen Gaseinlaß (510), der wirksam mit einem Gasverteilungsraum (506) verbunden ist, wobei der Gasverteilungsraum (506) durch die Anode (106) von dem Plasmaraum (110) getrennt ist.

8. Vorrichtung nach einem der Ansprüche 1 bis 7, dadurch gekennzeichnet,
daß die Multischlitzstruktur der Kathode und/oder die nachfolgenden Multischlitzstrukturen durch parallel zueinander angeordnete Platten (804; 804a, 804b) gebildet sind, an die eine Wechselspannung zur Erzeugung eines elektrischen Wechselfeldes anlegbar ist, wodurch leichte Ionen aus dem Multibandstrahl herausgefiltert werden können.

9. Vorrichtung nach Anspruch 8, gekennzeichnet durch
eine Multischlitzgitterstruktur, die an dem der Probe zugewandten Ende der Multischlitzstruktur der Kathode oder der nachfolgenden Multischlitzstrukturen derart angeordnet ist, daß deren Stege (820) im Strahlengang des Ionenstrahls (814) liegen, wodurch leichtere und schwerere Ionen von den gewünschten Ionen in dem Multi-bandstrahl getrennt werden können.

10. Vorrichtung nach Anspruch 8 oder 9, dadurch gekennzeichnet,
daß die Multischlitzstruktur der Kathode und/oder die nachfolgenden Multischlitzstrukturen eine Mehrzahl von Multischlitzgitterstrukturen umfaßt, die eine Kammstruktur (804a, 804b) haben, wobei die Multischlitzgitterkammstrukturen (804a, 804b) ineinandergeschoben sind.

11. Ionenstrahlanlage, mit einer Vorrichtung (100) nach einem der Ansprüche 1 bis 10.

12. Ionenstrahlanlage nach Anspruch 11, gekennzeichnet durch
einen Probenhalter (116) zur Aufnahme der Probe (104).

13. Ionenstrahlanlage nach Anspruch 11 oder 12, gekennzeichnet durch
eine Dosismeßeinrichtung (552,604,610) zum Messen der Dosis des von der Vorrichtung (100) ausgegebenen Ionenstrahls (122) und dessen Homogenität.

14. Ionenstrahlanlage nach Anspruch 13, dadurch gekennzeichnet,
daß die Dosismeßeinrichtung Faraday-Becher (552) umfaßt.

15. Ionenstrahlanlage nach Anspruch 13 oder 14, dadurch gekennzeichnet,

daß die Dosismeßeinrichtung in den Probenhalter (116) integriert ist, und

daß eine in situ Dosis- und Homogenitätsmessung möglich ist.

16. Ionenstrahlanlage nach einem der Ansprüche 11 bis 15, dadurch gekennzeichnet,
daß die Probe (104) aus Silizium besteht.

**Claims**

1. Apparatus for large-area implantation of ions into a specimen (104), comprising

an anode (106);

a cathode (108) produced from the same material as that of the specimen (104) towards which ions are emitted from the ion source (100), or coated with this material, or produced from a material which does not represent a contamination for said specimen (104), and

a plasma chamber (110) arranged between said anode (106) and said cathode (108);

characterized in

that the plasma chamber is closed;

that the cathode (108) comprises a multi-slot structure (200; 300) with juxtaposed slots which are separated by bars, the ions passing through said multi-slot structure whereby a multi-band beam is produced; and

that a voltage for generating an electric field perpendicular to the ion beam is applicable to the cathode or to subsequent multi-slot structures for extracting and accelerating the multi-band beam, said voltage being applied in such a way that the bars have different polarities.

2. Apparatus according to claim 1, characterized in that the multi-slot structure of the cathode and/or the subsequent multi-slot structures is/are formed by a plurality of multi-slot grid structures (200; 300) which are insulated from one another.

3. Apparatus according to claim 2, characterized in that the multi-slot structure of the cathode and/or the subsequent multi-slot structures is/are formed by a plurality of superimposed multi-slot grid structures (200).

4. Apparatus according to claim 2, characterized in that the multi-slot structure of the cathode and/or the subsequent multi-slot structures comprise(s) a plurality of multi-slot grid structures having a comb structure (300), said multi-slot grid comb structures (300) being interleaved.

5. Apparatus according to one of the claims 1 to 4, characterized in that, at least in the case of reactive gases, also the anode (106) is produced from the same material as that of the specimen (104), or is produced from a material which does not represent a contamination for the specimen (104).

6. Apparatus according to one of the claims 1 to 5, characterized in that, in the areas in which the plasma chamber (110) is delimited neither by the anode (106) nor by the cathode (108), said plasma chamber (110) is delimited by a non-metallic structure (126), such as a quartz structure, whereby an additional inductive high-frequency coupling is permitted.

7. Apparatus according to one of the claims 1 to 6, characterized by a gas inlet (510) which is effectively connected to a gas distribution chamber (506), said gas distribution chamber (506) being separated from the plasma chamber (110) by the anode (106).

8. Apparatus according to one of the claims 1 to 7, characterized in that the multi-slot structure of the cathode and/or the subsequent multi-slot structures is/are formed by plates (804; 804a, 804b) which are arranged parallel to one another and to which an alternating voltage can be applied for generating an alternating electric field, whereby light ions can be filtered out of the multi-band beam.

9. Apparatus according to claim 8, characterized by a multi-slot grid structure which is arranged at that end of the multi-slot structure of the cathode or of the subsequent multi-slot structures which faces the specimen, said multi-slot grid structure being arranged in such a way that the bars (820) thereof are located in the beam path of the ion beam (814), whereby lighter and heavier ions can be separated from the desired ions in the multi-band beam.

10. Apparatus according to claim 8 or 9, characterized in that the multi-slot structure of the cathode and/or the subsequent multi-slot structures comprise(s) a plurality of multi-slot grid structures having a comb structure (804a, 804b), said multi-slot grid comb structures (800a, 804b) being interleaved.

11. Ion beam unit comprising an apparatus (100) according to one of the claims 1 to 10.

12. Ion beam unit according to claim 11, characterized by a specimen holder (116) for receiving thereon the specimen (104).

13. Ion beam unit according to claim 11 or 12, characterized by a dose measurement unit (552, 604, 610) for measuring the dose of the ion beam (122) emitted by the apparatus (100) and the homogeneity of said ion beam (122).

14. Ion beam unit according to claim 13, characterized in that the dose measurement unit comprises Faraday collectors (552).

15. Ion beam unit according to claim 13 or 14, characterized in

that the dose measurement unit is integrated in the specimen holder (116), and

that an in situ dose and homogeneity measurement can be carried out.

16. Ion beam unit according to one of the claims 11 to 15, characterized in that the specimen (104) consists of silicon.

**Revendications**

1. Dispositif d'implantation d'ions à grande surface dans un échantillon (104), avec

une anode (106) ;

une cathode (108) réalisée dans le même matériau que celui de l'échantillon (104) vers lequel sont dégagés des ions de la source ionique (100), ou revêtue de celui-ci, ou réalisée en un matériau ne représentant pas de contamination pour l'échantillon (104),

et une chambre à plasma (110) disposée entre l'anode (106) et la cathode (108) ;

caractérisé par le fait

que la chambre à plasma est fermée ;

que la cathode (108) comporte une structure à fentes multiples (200 ; 300), à fentes adjacentes séparées par des bretelles, traversée par les ions, et générant ainsi un faisceau à bandes multiples ; et

qu'à la cathode ou à des structures à fentes multiples successives peut être appliquée, pour l'extraction et l'accélération du faisceau à bandes multiples, une tension destinée à générer un champ électrique perpendiculaire au faisceau ionique, de sorte que les bretelles présentent des polarités différentes.

2. Dispositif suivant la revendication 1, caractérisé par le fait que la structure à fentes multiples de la cathode et/ou les structures à fentes multiples successives sont constituées d'une pluralité de structures de grille à fentes multiples (200 ; 300) isolées l'une de l'autre.

3. Dispositif suivant la revendication 2, caractérisé par le fait que la structure à fentes multiples de la cathode et/ou les structures à fentes multiples successives sont constituées d'une pluralité de structures de grille à fentes multiples (200) disposées superposées.

4. Dispositif suivant la revendication 2, caractérisé par le fait que la structure à fentes multiples de la cathode et/ou les structures à fentes multiples successives comporte une pluralité de structures de grille à fentes multiples ayant une structure en peigne (300), les structures en peigne à grille à fentes multiples étant engagées l'une dans l'autre.

5. Dispositif suivant l'une des revendications 1 à 4, caractérisé par le fait que l'anode (106) est également réalisée, au moins dans le cas de gaz réactifs, dans le même matériau que celui de l'échantillon (104), ou dans un matériau ne représentant pas de contamination pour l'échantillon (104).

6. Dispositif suivant l'une des revendications 1 à 5, caractérisé par le fait que la chambre à plasma (110) est délimitée, à des endroits où elle n'est pas délimitée par l'anode (106) et la cathode (108), par une structure non-métallique (126), telle qu'une structure en quartz, d'où il est rendu possible un couplage de haute fréquence inductif supplémentaire.

7. Dispositif suivant l'une des revendications 1 à 6, caractérisé par une entrée de gaz (510) qui est reliée effectivement à une chambre de répartition de gaz (506), la chambre de répartition de gaz (506) étant séparée de la chambre à plasma (110) par l'anode (106).

8. Dispositif suivant l'une des revendications 1 à 7, caractérisé par le fait que la structure à fentes multiples de la cathode et/ou les structures à fentes multiples successives sont constituées par des plaques (804 ; 804a, 804b) disposées parallèles entre elles, auxquelles peut être appliquée une tension alternative destinée à générer un champ électrique alternatif par lequel des ions légers peuvent être dégagés par filtration du faisceau à bandes multiples.

9. Dispositif suivant la revendication 8, caractérisé par une structure de grille à fentes multiples disposée à l'extrémité, orientée vers l'échantillon, de la structure à fentes multiples de la cathode ou des structures à fentes multiples successives de sorte que leurs bretelles (820) se situent sur la trajectoire du faisceau ionique (814), d'où des ions plus légers et plus lourds peuvent être séparés des ions souhaités dans le faisceau à bandes multiples.

10. Dispositif suivant la revendication 8 ou 9, caractérisé par le fait que la structure à fentes multiples de la cathode et/ou les structures à fentes multiples successives comportent une pluralité de structures de grille à fentes multiples présentant une structure en peigne (804a, 804b), les structures en peigne à grille à fentes multiples (804a, 804b) étant emboîtées l'une dans l'autre.

11. Système à faisceau ionique, avec un dispositif (100) suivant l'une des revendications 1 à 10.

12. Système à faisceau ionique suivant la revendication 11, caractérisé par un porte-échantillon (116) destiné à recevoir l'échantillon (104).

13. Système à faisceau ionique suivant la revendication 11 ou 12, caractérisé par un dispositif de mesure de dose (552, 604, 610) destiné à mesurer la dose du faisceau ionique (122) émis par le dispositif (100) et son homogénéité.

14. Système à faisceau ionique suivant la revendication 13, caractérisé par le fait que le dispositif de mesure de dose comporte des cages de Faraday (552).

**15.** Système à faisceau ionique suivant la revendication 13 ou 14, caractérisé par le fait

   que le dispositif de mesure de dose est intégré dans le porte-échantillon (116), et qu'une mesure de dose et d'homogénéité sur place est possible.

**16.** Système à faisceau ionique suivant l'une des revendications 11 à 15, caractérisé par le fait que l'échantillon (104) est en silicium.

*FIG.1*

FIG.2

FIG.3

120 120

- + - + -

- - - -

200 BZW. 300

400 400 400

*FIG.4*

FIG.5

532

ROBOTER 546

116

538

122

552 602

552 602

IONENQUELLE 100

604

VAKUUMPUMPE

612

104

552 602

610

532

550

606

608

**FIG.6**

**FIG.7**

FIG.8